Europäisches Patentamt

European Patent Office

Office européen des brevets

(11) Publication number: **0 102 795**

**B1**

(12) EUROPEAN PATENT SPECIFICATION

(45) Date of publication of patent specification: **11.11.87**

(21) Application number: **83304813.5**

(22) Date of filing: **19.08.83**

(51) Int. Cl.⁴: **H 01 L 23/52, H 01 L 27/08**

(54) A method of manufacturing a semiconductor device using the master slice technique.

(30) Priority: **27.08.82 JP 148901/82**

(43) Date of publication of application:
**14.03.84 Bulletin 84/11**

(45) Publication of the grant of the patent:
**11.11.87 Bulletin 87/46**

(84) Designated Contracting States:
**DE FR GB**

(56) References cited:
**US-A-3 573 488**
**US-A-4 223 277**

**IBM TECHNICAL DISCLOSURE BULLETIN, vol.
24, no. 11A, April 1982, New York M.J.
HARGROVE et al "Masterslice universal book
design", pages 5450-5452**

(73) Proprietor: **FUJITSU LIMITED**
**1015, Kamikodanaka Nakahara-ku
Kawasaki-shi Kanagawa 211 (JP)**

(72) Inventor: **Shirato, Takehide
6-26 Sengen-cho
Hiratsuka-shi Kanagawa 254 (JP)**
Inventor: **Wada, Kensaku
Fujisawa-danchi 19-403
1-13 Fujigaoka Fujisawa-shi Kanagawa 251 (JP)**
Inventor: **Yuasa, Kouichi
1-5-14-44 Sobudaidanchi
Sagamihara-shi Kanagawa 226 (JP)**

(74) Representative: **Rackham, Stephen Neil et al
GILL JENNINGS & EVERY 53-64 Chancery Lane
London WC2A 1HN (GB)**

## Description

The present invention relates to a method for manufacturing a semiconductor device using the master slice technique and to a semiconductor device so manufactured and more particularly, to a method for manufacturing a metal-insulator-semiconductor (MIS) type integrated circuit device (IC) having general purpose output stages.

A MIS IC such as a microcomputer includes a number of logic circuits. Some of the logic circuits have output circuits. In each output circuit, the final output-stage transistor is designed to be an N-channel open-drain output type, i.e. a type in which current flows out from an output pad, when the microcomputer is used to drive a cathode ray tube (CRT) display, for example to provide a positive voltage of, for example, 12V. Alternatively the final output stage transistor may be a P-channel open drain output type, i.e. a type in which current flows into an output pad, for example, when a microcomputer is used to drive a fluorescent display tube to provide a negative voltage of, for example −40V. Conventionally the final output-stage transistor is manufactured to be one or the other in accordance with user requirements.

This causes problems in having to choose the type of output transistor as of one or other type and naturally limits the applications of each device. If it is required to be able to select which output type is required, the manufacture of the semiconductor device is complicated because it is necessary to change masks for forming diffusion regions in the final output-stage transistor depending on the type of transistor required to be formed. Diffusion is one of the earlier manufacturing steps, and thus it is impossible for a manufacturer to proceed with the later manufacturing steps in advance of an order for a particular device if the user wishes to have flexibility in choosing the type of output. This prevents the fast customisation of the MIS IC after receipt of an order.

US—A—4223277 describes a field effect transistor amplifier which is intended to be used as the output buffer of a semiconductor memory and which has an active pull up configuration. In addition to this the device includes an electrically alterable element such as a fusible element or a P—N junction to enable the connection between an output terminal and the drain of one of the transistors of the amplifier to be broken and thereby enable the amplifier configuration to be changed to that of an open drain after the formation and testing of the memory device has been completed.

According to this invention a method of manufacturing a semiconductor device by the master slice technique in which at least one semiconductor device is formed including a final output stage having a MIS field effect transistor with a gate, a source and a drain, and in which in a customising step, wiring is connected to the output stage is characterised in that both a P-channel MIS field effect transistor and an N-channel MIS field effect transistor are provided in the final output stage, and in that the customising step includes forming wiring to connect only one of the P-channel or N-channel output transistors to the remainder of the circuits of the device and the drain of the selected one of the P-channel or N-channel output transistors simultaneously to the output terminals thereby to form an integrated circuit of either the open-drain P- or N-channel output type.

Embodiments of the method and devices in accordance with this invention will now be described with reference to the accompanying drawings; in which:—

Figure 1A is a circuit diagram of a first embodiment of an output-stage circuit of a master slice before the wiring process;

Figure 1B is a circuit diagram of the output-stage circuit after a wiring process to form a P-channel open-drain output;

Figure 1C is a circuit diagram of the output-stage circuit after a wiring process to form an N-channel open-drain output;

Figures 2A to 2C are plans illustrating the manufacturing steps of the circuit shown in Figure 1B;

Figure 3 is a cross section taken along the line III—III' shown in Figure 2C;

Figure 4A is a circuit diagram of a second embodiment of an output-stage circuit of a master slice before an electrode window process;

Figure 4B is a circuit diagram of the output-stage circuit after an electrode-window process to form a P-channel open-drain output;

Figure 4C is a circuit diagram of the output-stage circuit after an electrode window process to form an N-channel open-drain output;

Figures 5A to 5C are plans illustrating the manufacturing steps of the circuit shown in Figure 4B;

Figure 6 is a cross section taken along the line VI—VI' shown in Figure 5c;

Figure 7A is a plan of a third embodiment of an output-stage circuit having transistors with a high tolerance voltage;

Figure 7B is a cross-section taken along the line VIIB—VIIB' shown in Figure 7A;

Figure 7C is a cross section taken along the line VIIC—VIIC' shown in Figure 7A;

Figure 8A is a plan of a fourth embodiment of an output stage circuit having transistors with different tolerance voltages;

Figure 8B is a cross section taken along the line VIIIB—VIIIB' shown in Figure 8A;

Figure 8C is a cross section taken along the line VIIIC—VIIIC' shown in Figure 8C;

Figure 9A is a plan of a fifth embodiment illustrating an output stage circuit having transistors with a high tolerance voltage;

Figure 9B is a cross section taken along the line IXB—IXB' shown in Figure 9A;

Figure 9C is a cross-section taken along the line IXC—IXC' shown in Figure 9A;

Figure 10A is a plan of a sixth embodiment of an output-stage circuit having transistors with different tolerance voltages;

Figure 10B is a cross section taken along the line XB—XB' shown in Figure 10A; and,

Figure 10C is a cross section taken along the line XC—XC' shown in Figure 10A.

In the method for manufacturing MIS or metal-oxide-semiconductor (MOS) IC's according to the present invention, both an N-channel MOS field effect transistor and a P-channel MOS field transistor are arranged in the final output stage of each of a plurality of output circuits integrated in the IC.

Before customization, the IC manufactured according to the present invention includes transistors for constructing logic circuits, transistors for constructing output circuits, and two types of MOS field effect transistors with different conductivities in the final output stages. These transistors themselves are manufactured by conventional techniques. After forming these transistors, the IC is covered by an insulating film. During customization to specific user designs, each output stage is formed as a P-channel open-drain output type or an N-channel open-drain output type by appropriately wiring an output pad to the desired P-channel or N-channel MOS field effect transistors. This method enables reduction of the time needed by a manufacturer to form a desired IC after receiving a user order.

According to a first embodiment of the present invention, the desired P-channel open-drain output type or N-channel open-drain output type is formed in the final output stage of a MOS IC by a wiring master slice method. "Wiring master slice method" means a master slice process using wiring patterns for customization.

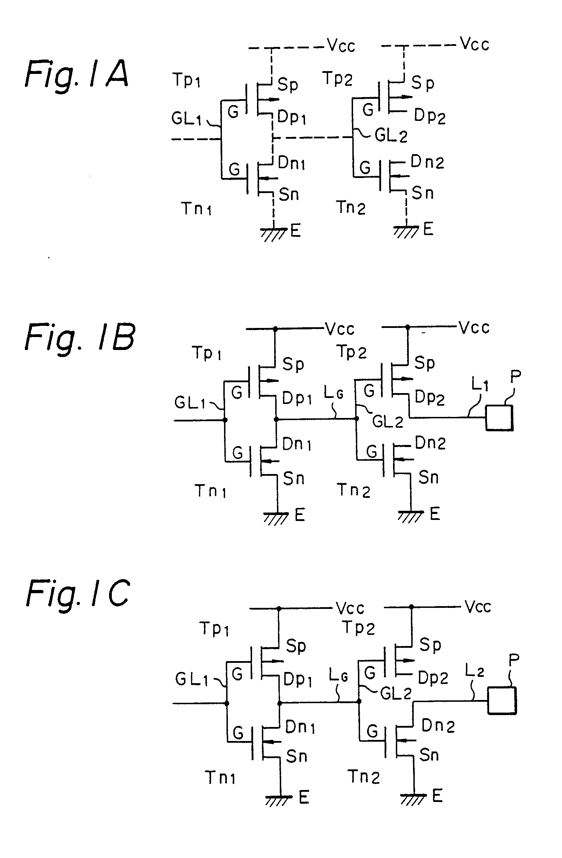

Figures 1A through 1C are circuit diagrams of an output-stage circuit illustrating the manufacturing steps according to the first embodiment. Among the figures, Fig. 1A shows the output-stage circuit before the wiring master slice process. In Fig. 1A, there are formed, on a substrate of an IC to be processed, a first P-channel MOS field effect transistor $T_{p1}$ and a first N-channel MOS field effect transistor $T_{n1}$ as semi-conductor elements for constructing an output circuit of, for example, an output inverter, and a second P-channel MOS field effect transistor $T_{p2}$ and a second N-channel MOS field effect transistor $T_{n2}$ as elements of a final output stage. In the figure, reference notations G represent gates, $G_{L1}$ and $G_{L2}$ gate electrodes; $S_p$ P-type sources; $S_n$ N-type sources; $D_{p1}$ and $D_{p2}$ P-type drains; $D_{n1}$ and $D_{n2}$ N-type drains; $V_{cc}$ power supplies or power supply lines; and E the ground. Dash lines represent wirings to be formed in the later manufacturing steps.

Figure 1B shows the output-stage circuit of Fig. 1A after the wiring master slice process to form a P-channel open-drain output type. In Fig. 1B, the drain $D_{p2}$ of the second P-channel MOS field effect transistor $T_{p2}$ is connected to an output pad P by a wire $L_1$. This wiring is carried out by a master slice method. During the wiring master slice procedure, the power supply line $V_{cc}$, the wirings for connecting the power supply line $V_{cc}$ and the sources $S_p$ of the transistors $T_{p1}$ and $T_{p2}$, a wiring line $L_G$ for connecting the drains $D_{p1}$ and $D_{n1}$ to the gate electrode $G_{L2}$, and wirings for connecting the sources $S_n$ and the ground E are simultaneously formed with the wire $L_1$.

Figure 1C shows the output-stage circuit of Fig. 1A after the wiring master slice process to form an N-channel open-drain output type. In Fig. 1C, the drain $D_{n2}$ of the second N-channel MOS transistor $T_{n2}$ is connected to the output pad P by a wire $L_2$. This wiring is also carried out by a master slice method. During the master slice procedure, the other wirings are also simultaneously made in the same way as in the device of Fig. 1B.

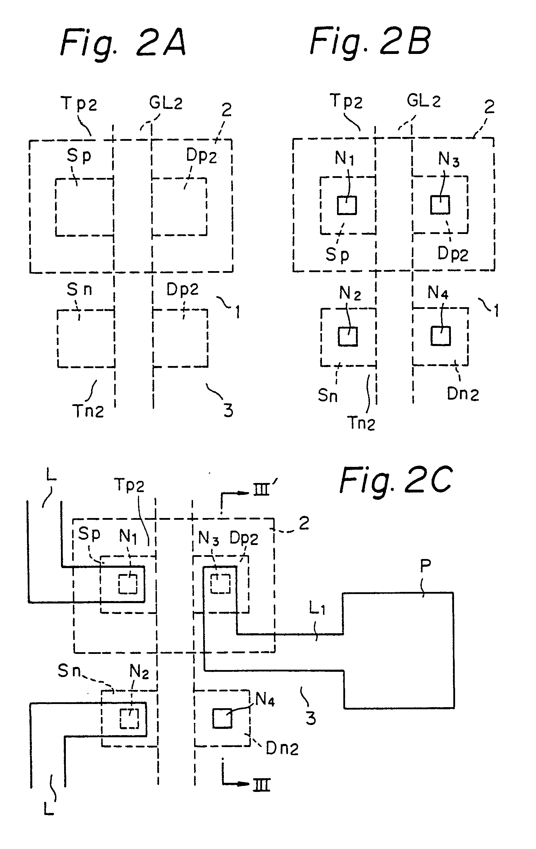

Figures 2A through 2C are plan views illustrating the manufacturing steps of the final stage of the circuit of Fig. 1B. Figure 2A shows the IC substrate corresponding to the final stage of the circuit of Fig. 1A before customization to a P-channel open-drain output type or N-channel open-drain output type. In Fig. 2A, reference numeral 1 represents a P-type semiconductor substrate; 2 an N-type well; 3 an insulating film and covering the surface of the IC; $T_{p2}$ the second P-channel MOS field effect transistor; $T_{n2}$ the second N-channel MOS field effect transistor; $G_{L2}$ the gate electrode; $S_p$ the P-type source region; $S_n$ the N-type source region; $D_{p2}$ the P-type drain region; and $D_{n2}$ the N-type drain region.

According to the first embodiment, when a user orders a P-channel open-drain output type, electrode-contact windows such as $N_1$, $N_2$, $N_3$, and $N_4$ shown in Fig. 2B are formed, by a conventional photolithography technique, on the source and drain regions of all of the transistors, including transistors not shown in Fig. 2B. Then, a wiring-material layer such as an aluminum (Al) layer is formed on the substrate. After this, a wire-forming mask having the output wiring pattern appropriate for the user's needs, in this case an output wiring pattern for providing a P-channel open-drain output type, is used for patterning of the aluminum layer by means of a conventional photolithography technique. Thus, as illustrated in Fig. 2C, the output wiring $L_1$ having the output pad P and source wirings L are formed on the insulating film 3. The output wiring $L_1$ is in contact via the electrode-contact window $N_3$ with the drain region $D_{p2}$ of the final-stage P-channel MOS field effect transistor $T_{p2}$. During this patterning procedure, the other aluminum wirings, such as those for constructing logic circuits are those for constructing output circuits, are simultaneously formed by a conventional master slice method.

It should be noted that, in Figs. 2A through 2C, a well contact region for providing a potential to the N-type well and substrate contact region for providing a potential to the substrate 1 are not shown for the sake of simplicity.

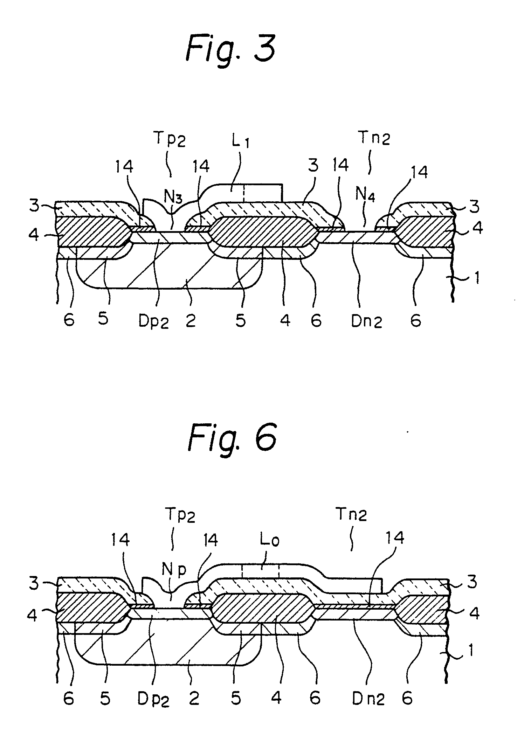

Figure 3 is a cross-sectional view, taken along line III—III' of Fig. 2C, which represents the final output stage after the above-mentioned wiring process. In Fig. 3, reference numeral 1 represents the P-type semiconductor substrate; 2 the N-type well; 3 the insulating film between layers; 4 a field oxidation film; 5 $N^+$-type channel cut regions; 6 $P^+$-type channel cut regions, 14 thin oxidation films; $T_{p2}$ the P-channel MOS field effect transistor; $T_{n2}$ the N-channel MOS field effect transistor; $D_{p2}$ the P-type drain region; $D_{n2}$ the N-type drain region; $N_3$ and $N_4$ electrode-contact windows; and $L_1$ the output wiring.

After the formation of the above-mentioned wirings, the IC is covered by a surface-protecting film such as phospho-silicate glass (PSG).

According to a second embodiment of the present invention, the desired P-channel open-drain output type or N-channel open-drain output type is formed in the final output stage of a MOS IC by an electrode-window master slice method. "Electrode-window master slice method" means a master slice process forming desired electrode windows.

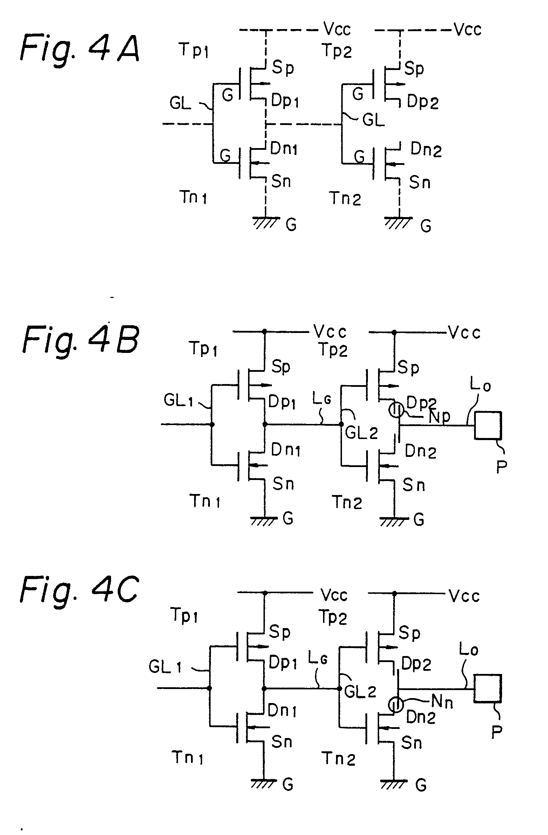

Figures 4A through 4C are diagrams of an output-stage circuit illustrating the manufacturing steps according to the second embodiment of the present invention. Among the figures, Fig. 4A shows the output-stage circuit before the electrode-window master slice process. The structure of the circuit of Fig. 4A is similar to the structure of the circuit of Fig. 1A. In Fig. 4A, reference notations are similar to those in Fig. 1A, that is, $T_{p1}$ and $T_{n1}$ represent a first P-channel MOS field effect transistor and a first N-channel MOS field effect transistor, respectively, for forming an output inverter; $T_{p2}$ and $T_{n2}$ a second P-channel MOS field effect transistor and a second N-channel MOS field effect transistor, respectively, for forming a final output stage; G gates; $G_{L1}$ and $G_{L2}$ gate electrodes; $S_p$ P-type sources; $S_n$ N-type sources; $D_{p1}$ and $D_{p2}$ P-type drains; $D_{n1}$ and $D_{n2}$ N-type drains; $V_{cc}$ power supplies or power supply lines; and E the ground. Dash lines represent wirings to be formed in the later manufacturing steps.

Figure 4B shows the output-stage circuit of Fig. 4A after the electrode-window master slice process to form a P-channel open-drain output type. In Fig. 4B, an electrode-contact window $N_p$ is formed on the drain $D_{p2}$ of the P-channel MOS field effect transistor $T_{p2}$. No electrode-contact window is formed on the drain $D_{n2}$ of the N-channel MOS field effect transistor $T_{n2}$. The drain $D_{p2}$ of the P-channel MOS field effect transistor $T_{p2}$ is connected via the electrode-contact window $N_p$ to an output wiring $L_0$ which is connected to an output pad P. The drain $D_{n2}$ of the N-channel MOS field effect transistor $T_{n2}$ is not connected to the output wiring $L_0$. Thus, a P-channel open-drain output type is formed.

Figure 4C shows the output-stage circuit of Fig. 4A after the electrode-window master slice process to form an N-channel open-drain type. In Fig. 4C, an electrode-contact window $N_n$ is formed on the drain $D_{n2}$ of the N-channel MOS field effect transistor $T_{n2}$. No electrode-contact window is formed on the drain $D_{p2}$ of the P-channel MOS field effect transistor $T_{p2}$. The drain $D_{p2}$ of the N-channel MOS field effect transistor $T_{n2}$ is connected via the electrode-contact window $N_n$ to the output wiring $L_0$, which is connected to the output pad P. The drain $D_{p2}$ of the P-channel MOS field effect transistor $T_{p2}$ is not connected to the output wiring $L_0$. Thus, an N-channel open-drain output type is formed.

In Fig. 4B or 4C, the power supply line $V_{cc}$, the wirings for connecting the power supply line $V_{cc}$ and the sources $S_p$ of the transistors $T_{p1}$ and $T_{p2}$, a wiring line $L_G$ for connecting the drains $D_{p1}$ and $D_{n1}$ to the gate electrode $GL_2$, wirings for connecting the sources $S_n$ and the ground E are simultaneously formed with the formation of the above-mentioned output wiring $L_0$ during the electrode-window master slice procedure.

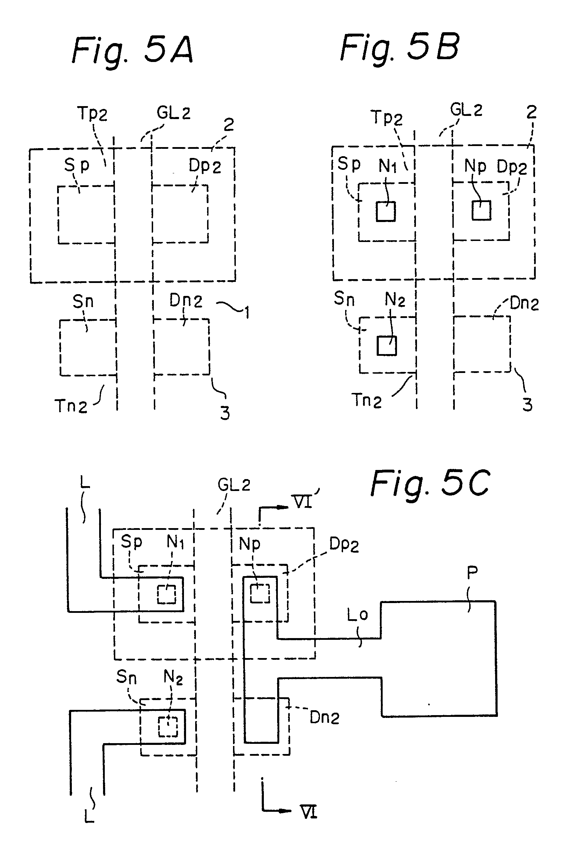

Figures 5A through 5C are plan views illustrating the manufacturing steps of the final stage of the circuit of Fig. 4B. Figure 5A shows the IC substrate corresponding to the final stage of the circuit of Fig. 4A before customization to a P-channel open-drain output type or N-channel open-drain output type. In Fig. 5A, reference numeral 1 represents the P-type semiconductor substrate; 2 the N-type well; 3 the insulating film covering the surface of the IC; $T_{p2}$ the second P-channel MOS transistor; $G_{L2}$ the gate electrode; $S_p$ the P-type source region; $S_n$ the N-type source region; $D_{p2}$ the P-channel drain region; and $D_{n2}$ the N-type drain region.

According to the second embodiment, when a user orders, for example, a P-channel open-drain output type, the electrode-contact window $N_p$ for connecting the drain $D_{p2}$ of the P-channel MOS field effect transistor $T_{p2}$ to the output wiring $L_0$ is formed only on the drain $D_{p2}$ of the P-channel MOS field effect transistor $T_{p2}$ in the final output stage, as illustrated in Fig. 5B, an electrode-window forming mask having the pattern to form the electrode-contact window appropriate for the users needs, in this case, the pattern for providing an electrode-contact window on the drain $D_{p2}$ of the P-channel MOS field effect transistor $T_{p2}$. No electrode-contact window is formed on the drain $D_{n2}$ of the N-channel MOS field effect transistor $T_{n2}$. During the procedure of forming the electrode-contact window $N_p$, electrode-contact windows $N_1$ and $N_2$, corresponding to the sources $S_p$ and $S_n$ of the transistors $T_{p2}$ and $T_{s2}$ in the final output stage, and other electrode-contact windows, corresponding to sources and drains of transistors for constructing output circuits and logic circuits on a region not illustrated in Fig. 5B, are, simultaneously formed.

Then, a wiring material layer such as an aluminum (Al) layer is formed on the substrate. Patterning is carried out by means of a conventional photolithography technique to form source wirings L and the output wiring $L_0$ as illustrated in Fig. 5C. The output wiring $L_0$ has at its end the output pad P and extends on the upper portions of the drains $D_{p2}$ and $D_{n2}$ of the P-channel MOS field effect transistor $T_{p2}$ and the N-channel MOS field effect transistor $T_{n2}$ as illustrated in Fig. 5C. Thus, the drain $D_{p2}$ of the P-channel MOS field effect transistor $T_{p2}$ is connected via the electrode-contact window $N_p$ to the output wiring $L_0$, resulting in the desired P-channel open-drain output type. During the patterning procedure, the other aluminum wirings, such as those for constructing logic circuits or those for constructing output circuits, are simultaneously formed.

It should be noted that, in Figs. 5A through 5C, a well contact region for providing a potential to the N-type well and a substrate contact region for providing a potential to the substrate 1 are not shown for the sake of simplicity.

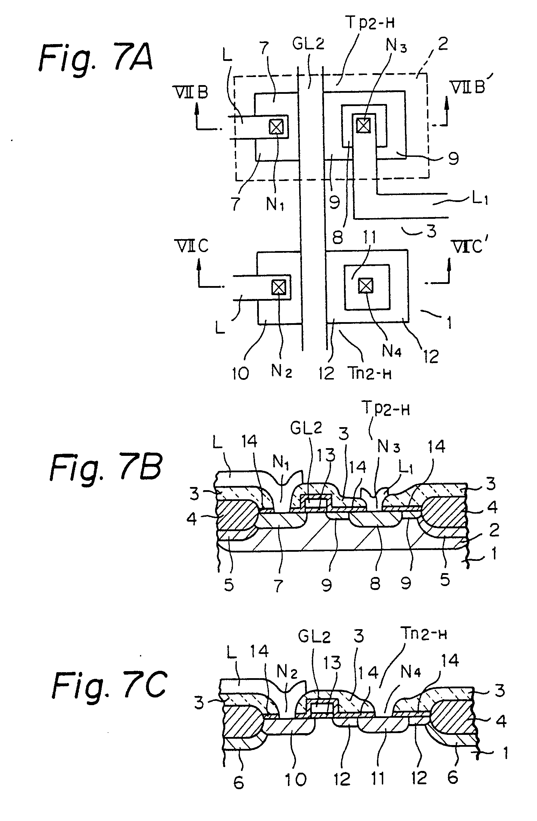

Figure 6 is a cross-sectional view taken along line VI—VI' of Fig. 5C and represents the final output stage after the above-mentioned wiring process. In Fig. 6, reference numeral 1 represents the P-type semiconductor substrate; 2 the N-type well; 3 the insulating film; 4 a field oxidation film; 5 $N^+$-type channel cut regions; 6 $P^+$-type channel cut regions; 14 thin oxidation films; $T_{p2}$ the P-channel MOS field effect transistor; $T_{n2}$ the N-channel MOS field effect transistor; $D_{p2}$ the P-type drain region; $D_{n2}$ the N-type drain region; and $L_0$ the output wiring.

After the formation of the above-mentioned wirings, the IC is covered by a surface-protecting film such as PSG.

Figure 7A is a plan view of an output-stage circuit after a wiring master slice process, according to a third embodiment of the present invention; Fig. 7B is a cross-sectional view taken along line VIIB—VIIB' of Fig. 7A; and Fig. 7C is a cross-sectional view taken along line VIIC—VIIC' of Fig. 7A. In these figures, an N-channel MOS field effect transistor $T_{n2-H}$ and a P-channel MOS field effect transistor $T_{p2-H}$ in the final output stage are made to have a high tolerance voltage.

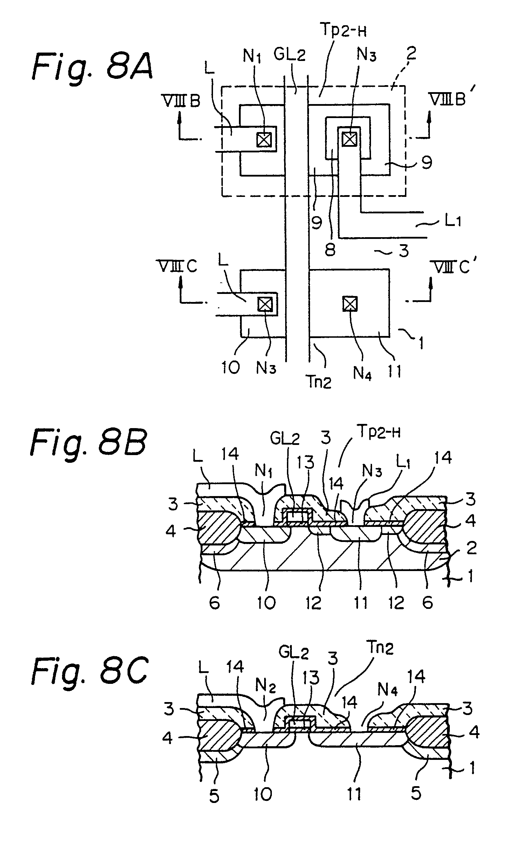

Figure 8A is a plan view of an output-stage circuit after a wiring master slice process, according to a fourth embodiment of the present invention; Fig. 8B is a cross-sectional view taken along line VIIIB—VIIIB' of Fig. 8A; and Fig. 8C is a cross-sectional view taken along line VIIIC—VIIIC' of Fig. 8A. In these figures, a P-channel MOS field effect transistor $T_{p2-H}$ and an N-channel MOS field effect transistor $T_{n2}$ are given different tolerance voltages. That is, the P-channel MOS field effect transistor $T_{p2-H}$ has a high tolerance voltage, and the N-channel MOS field effect transistor $T_{n2}$ has a normal tolerance voltage. Of course, the P-channel MOS field effect transistor may alternatively be given a normal tolerance voltage, and the N-channel MOS transistor may alternatively be given a high tolerance voltage.

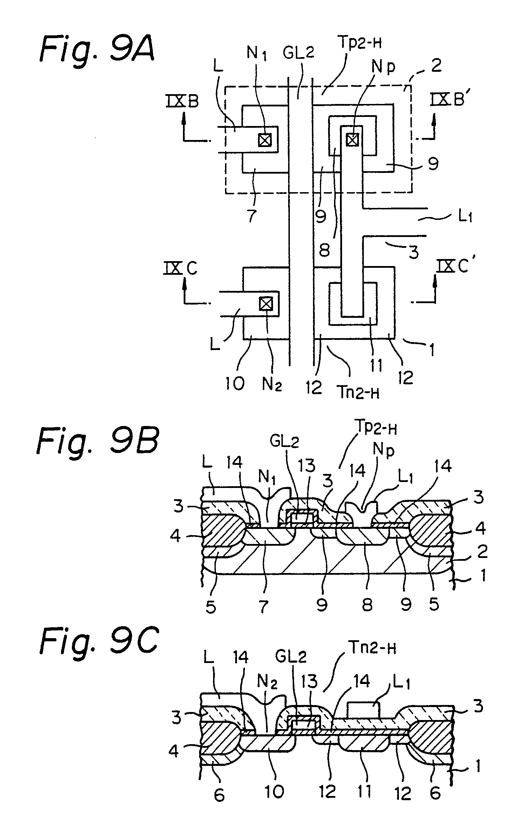

Figure 9A is a plan view of an output-stage circuit after an electrode-window master slice process, according to a fifth embodiment of the present invention; Fig. 9B is a cross-sectional view taken along line IXB—IXB' of Fig. 9A; and Fig. 9C is a cross-sectional view taken along line IXC—IXC' of Fig. 9A. In these figures, an N-channel MOS field effect transistor $T_{n2-H}$ and a P-channel MOS field effect transistor $T_{p2-H}$ in the final output stage are given a high tolerance voltage.

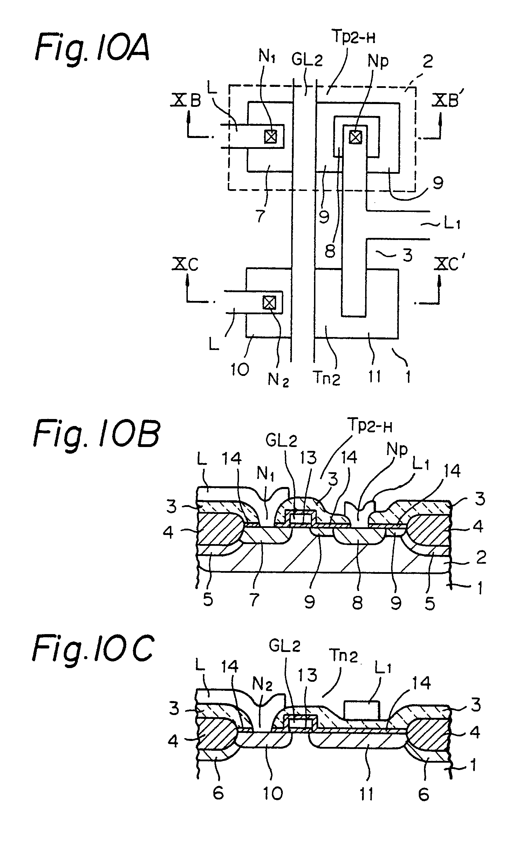

Figure 10A is a plan view illustrating an output-stage circuit after an electrode-window master slice process, according to a sixth embodiment of the present invention; Fig. 10B is a cross-sectional view taken along line XB—XB' of Fig. 10A; and Fig. 10C is a cross-sectional view taken along line XC—XC' of Fig. 10A. In these figures, a P-channel MOS field effect transistor $T_{p2-H}$ and an N-channel MOS field effect transistor $T_{n2}$ are given different tolerance voltages. That is, the P-channel MOS field effect transistor $T_{p2}$ has a high tolerance voltage, and the N-channel MOS field effect transistor $T_{n2}$ has a normal tolerance voltage. Of course, the P-channel MOS field effect transistor may alternatively be given a normal tolerance voltage, and the N-channel MOS field effect transistor may alternatively be given a high tolerance voltage.

Referring to Figs. 7A through 7C, 8A through 8C, 9A through 9C, and 10A through 10C, reference numeral 1 represents a P-type semiconductor substrate; 2 an N-type well; 3 an insulating film; 4 a field oxidation film; 5 $N^+$-type channel cut regions; 6 $P^+$-type channel cut regions; 7 a $P^+$-type source region; 8 a $P^+$-type drain region; 9 a $P^-$-type drain region having a low impurity concentration; 10 an $N^+$-type source region; 11 an $N^+$-type drain region; 12 an $N^-$-type drain region; 13 a gate oxidation film; 14 a thin oxidation film; $T_{p2-H}$ the P-channel MOS field effect transistor having a high tolerance voltage; $T_{n2-H}$ the N-channel MOS field effect transistor having a high tolerance voltage; $T_{n2}$ the N-channel MOS field effect transistor having the normal tolerance voltage; $G_{L2}$ a gate electrode; $N_1$, $N_2$, $N_3$, $N_4$, and $N_p$ the electrode-contact windows; L the source wirings; and $L_1$ the output wiring.

The output-stage circuit of a P-channel open-drain output type with a high tolerance voltage P-channel MOS field effect transistor, as illustrated in Figs. 7A through 7C, Figs. 8A through 8C, Figs. 9A through 9C, or Figs. 10A through 10C, is effectively used to drive a minus-voltage driven unit such as a fluorescent display. Also, the output-stage circuit of an N-channel open-drain output type with a high tolerance voltage N-channel MOS field effect transistor is effectively used to drive a plus-voltage driven unit such as a CRT display tube.

Each of the illustrated embodiments shows a single output-stage circuit. In practice, however, there are a number of output-stage circuits in a MIS IC such as a microcomputer. All of the output-stage circuits in the MIC IC may be formed by any one or more of the foregoing embodiments. Alternatively, a selected part of the output-stage circuits may be formed by any one or more of the foregoing embodiments, and remaining output-stage circuits may be formed in a conventional way. That is, each of the remaining output-stage circuits may be manufactured to be a fixed N-channel or even a push-pull open-drain type or P-channel open-drain type.

From the foregoing description, it will be apparent that, according to the present invention, a MIS IC having a desired output type, i.e., a MIC IC having an N-channel open-drain output type or a P-channel open-drain output type, can be formed simultaneously with the formation of wirings by means of a wiring master slice process or with the formation of electrode-contact windows by means of a electrode-window master slice process.

Accordingly, a MIS IC having the output type desired by the user can be provided without increasing the manufacturing steps a short time after the user orders the manufacture of the MIS IC. As a result, according to the invention, a semiconductor device before wiring can conveniently be applied to general purposes, i.e., it is easy to form an N-channel MIS field effect transistor or a P-channel MIS field effect transistor in the final output stage.

**Claims**

1. A method of manufacturing a semiconductor device by the master slice technique in which at least one semiconductor device is formed including a final output stage having a MIS field effect transistor with a gate, a source and a drain, and in which, in a customising step, wiring is connected to the output stage characterised in that both a P-channel MIS field effect transistor $(T_{p2})$ and an N-channel MIS field effect transistor $(T_{n2})$ are provided in the final output stage, and in that the customising step includes forming wiring $(L, L_1)$ to connect only one of the P-channel or N-channel output transistors to the remainder of the circuits of the device and the drain $(D_{p2}, D_{n2})$ of the selected one of the P-channel or N-channel output transistor simultaneously to the output terminals (P) thereby to form an integrated circuit of either the open-drain P- or N-channel output type.

2. A method of manufacturing a semiconductor device comprising the steps of:

forming an N-channel MIS field effect transistor $(T_{n2})$ and a P-channel MIS field effect transistor $(T_{p2})$ in a final output stage of a semiconductor device, each of the N-channel and P-channel transistors comprising a gate, a source and a drain; and

forming an output wiring $(L_1)$ connected to a selected one of the drains $(D_{n2}, D_{p2})$ of the N-channel MIS field effect transistor, thereby forming an integrated circuit of an N-channel open-drain output type or a P-channel open-drain output type, and simultaneously forming a wiring (L) to connect the selected one of the N-channel MIS field effect transistors or the P-channel MIS field effect transistors to the remainder of the circuits of the device.

3. A method according to claim 1 or 2, further comprising forming electrode-contact windows on the upper portions of the drains of the P-channel MIS field effect transistor and the N-channel MIS field effect transistor and in which the formation of the output wiring comprises the step of forming the output wiring in a pattern extending to only a selected one of the electrode-contact windows so that the wiring is only connected to the selected one of the N-channel MIS field effect transistor or the P-channel MIS field effect transistor via the selected electrode-contact window.

4. A method according to claim 1 or 2, further comprising forming an electrode-contact window on the upper portion of the drain of a selected one of the P-channel MIS field effect transistor or the N-channel MIS field effect transistor, and in which the formation of the output wiring comprises the step of forming the output wiring in a pattern extending onto the upper portions of the drains of both of the P-channel MIS field effect transistor and the N-channel MIS field effect transistor so that the output wiring is connected to the selected one of the drains via the electrode-contact window.

5. A method according to any one of the preceding claims, in which the N-channel MIS field effect transistor and the P-channel MIS field effect transistors are formed with their drains having different tolerance voltages.

6. A method according to any one of the preceding claims, wherein the drains of at least one of the N-channel and the P-channel MIS field effect transistors are formed to have a high tolerance voltage in comparison with the tolerance voltage of the drains of other MIS field effect transistors integrated in the semiconductor device.

7. A semiconductor device comprising:

an N-channel MIS field effect transistor (Tn2) and a P-channel MIS field effect transistor (Tp2) formed in a final output stage of the semiconductor device, each of the N-channel (Tn2) and P-channel (Tp2) transistors comprising a gate (G), a source (Sp or Sn) and a drain (Dp2 or Dn2); and, characterised by

an output wiring comprising an output pad pattern (P) and an output wiring pattern (L1, L2) for connecting to the output pad pattern (P) a selected one of the drains (Dn2, Dp2) of the N-channel MIS field effect transistor or of the P-channel MIS field effect transistor (Tn2 or Tp2) to form an integrated circuit of an N-channel open-drain output type or a P-channel open-drain output type, the output wiring pattern (L1, L2) being formed by lithography so as to contact only the selected one of the drains.

8. A semiconductor device according to claim 7, further comprising electrode-contact windows (N3, N4) on the upper portions of the drains (Dp2, Dn2) of both the P-channel MIS field effect transistor (Tp2), and the N-channel MIS field effect transistor (Tn2), the output wiring (L1) having a pattern extending on a selected one of the electrode-contact windows (N3, N4) so as to be connected to the drain (Dp2, Dn2) of said selected one of the N-channel or P-channel MIS field effect transistors via a selected electrode-contact window.

9. A semiconductor device according to claim 7, further comprising an electrode-contact window (N3 or N4) on the upper portion of said selected one of the drains (Dp2, Dn2) of the P-channel MIS field effect transistor (Tp2) or the N-channel MIS field effect transistor (Tn2), the output wiring having a pattern extending onto the upper portions of the drains (Dp2 and Dn2) of both of the P-channel and N-channel MIS field effect transistors (Tkp2, Tn2) so that the output wire (L1) is connected only to the one selected drain via the electrode-contact window (N3 or N4).

10. A semiconductor device according to any one of claims 7, 8 or 9, wherein the drains (Dn2, Dp2) of the N-channel MIS field effect transistor (Tn2) and the P-channel MIS field effect transistor (Tp2) have different tolerance voltages.

11. A semiconductor device according to any one of claims 7, 8, 9 or 10, in which at least one of the drains (Dn2, Dp2) of the N-channel MIS field effect transistor (Tn2) and the P-channel MIS field effect transistor (Tp2) has a high tolerance voltage in comparison with the tolerance voltage of the drains of other MIS field effect transistors integrated in the semiconductor device.

**Patentansprüche**

1. Verfahren zur Herstellung einer Halbleitervorrichtung nach der 'Master-Slice'-Technik, bei dem wenigstens eine Halbleitervorrichtung gebildet wird, die eine endgültige Ausgangsstufe umfaßt, die einen MIS-Feldeffekttransistor mit einem Gate, einer Source und einem Drain hat, und bei dem, beim Kundenanpassungsschritt, die Verdrahtung mit der Ausgangsstufe verbunden wird, dadurch gekennzeichnet, daß sowohl ein P-Kanal-MIS-Feldeffekttransistor ($T_{p2}$) als auch ein N-Kanal-MIS-Feldeffekttransistor ($T_{n2}$) in der endgültigen Ausgangsstufe vorgesehen sind, und daß der Kundenanpassungsschritt die Bildung der Verdrahtung (L, $L_1$) einschließt, um nur einen der P-Kanal- oder N-Kanal-Ausgangstransistoren mit dem Rest der Schaltungen der Vorrichtung zu verbinden und das Drain ($D_{p2}$, $D_{n2}$) des ausgewählten einen der P-Kanal- oder N-Kanal-Ausgangstransistoren gleichzeitig mit den Ausgangsanschlüssen (P) zu verbinden, um dadurch eine integrierte Schaltung vom Typ eines P- oder N-Kanal-Ausgangs mit offenem Drain zu bilden.

2. Verfahren zur Herstellung einer Halbleitervorrichtung, mit den folgenden Schritten:

Bildung eines N-Kanal-MIS-Feldeffekttransistors ($T_{n2}$) und eines P-Kanal-MIS-Feldeffekttransistors ($T_{p2}$) in einer endgültigen Ausgangsstufe einer Halbleitervorrichtung, wobei jeder der N-Kanal- und P-Kanal-Transistoren ein Gate, eine Source und ein Drain umfaßt; und

Bildung einer Ausgangsverdrahtung ($L_1$), die mit einem ausgewählten der Drains ($D_{n2}$, $D_{p2}$) des N-Kanal-MIS-Feldeffekttransistors verbunden ist, wodurch eine integrierte Schaltung vom Typ eines N-Kanal-Ausgangs mit offenem Drain oder vom Typ eines P-Kanal-Ausgangs mit offenem Drain gebildet wird, und gleichzeitig Bildung einer Verdrahtung (L) um den ausgewählten der N-Kanal-MIS-Feldeffekttransistoren oder der P-Kanal-MIS-Feldeffekttransistoren mit dem Rest der Schaltungen der Vorrichtung zu verbinden.

3. Verfahren nach Anspruch 1 oder 2, bei dem ferner Elektrodenkontaktfenster auf den oberen Abschnitten der Drains des P-Kanal-MIS-Feldeffekttransistors und des N-Kanal-MIS-Feldeffekttransistors gebildet werden, und bei dem die Bildung der Ausgangsverdrahtung den Schritt der Bildung der Ausgangsverdrahtung in einem Muster umfaßt, welches sich nur auf ein ausgewähltes der Elektrodenkontaktfenster erstreckt, so daß die Verdrahtung, über das ausgewählte Elektrodenkontaktfenster, nur mit einem ausgewählten N-Kanal-MIS-Feldeffekttransistor oder P-Kanal-MIS-Feldeffekttransistor verbunden wird.

4. Verfahren nach Anspruch 1 oder 2, bei dem ferner ein Elektrodenkontaktfenster auf dem oberen Abschnitt des Drains des einen ausgewählten P-Kanal-MIS-Feldeffekttransistors oder N-Kanal-MIS-Feldeffekttransistor gebildet wird, und bei dem die Bildung der Ausgangsverdrahtung einen Schritt umfaßt, bei dem die Ausgangsverdrahtung in einem Muster geformt wird, das sich auf die oberen Abschnitte der Drains sowohl des P-Kanal-MIS-Feldeffekttransistors als auch des N-Kanal-MIS-Feldeffekttransistors erstreckt, so daß die Ausgangsverdrahtung mit dem ausgewählten Drain über das Elektrodenkontaktfenster verbunden wird.

5. Verfahren nach einem der vorhergehenden Ansprüche, bei dem der N-Kanal-MIS-Feldeffekttransistor und der P-Kanal-MIS-Feldeffekttransistor so gebildet werden, daß ihre Drains verschiedenen Toleranzspannungen haben.

6. Verfahren nach einem der vorhergehenden Ansprüche, bei dem die Drains von wenigstens einem der N-Kanal-und der P-Kanal-MIS-Feldeffekttransistoren so gebildet werden, daß sie eine hohe Toleranzspannung im Vergleich zu der Toleranzspannung der Drains der anderen MIS-Feldeffekttransistoren haben, die in der Halbleitervorrichtung integriert sind.

7. Halbleitervorrichtung mit:

einem N-Kanal-MIS-Feldeffekttransistor (Tn2) und einem P-Kanal-MIS-Feldeffekttransistor (Tp2), die in der endgültigen Ausgangsstufe der Halbleitervorrichtung gebildet sind, wobei jeder N-Kanal-(Tn2)- und P-Kanal-(Tp2)-Transistor ein Gate (G), eine Source (Sp oder Sn) und ein Drain (Dp2 oder Dn2) umfaßt; und,

gekennzeichnet durch

eine Ausgangsverdrahtung, die ein Ausgangspadmuster (P) und ein Ausgangsverdrahtungsmuster (L1, L2) umfaßt, um mit dem Ausgangspadmuster (P) ein ausgewähltes der Drains (Dn2, Dp2) des Kanal-MIS-Feldeffekttransistors oder des P-Kanal-MIS-Feldeffekttransistors (Tn2 oder Tp2) zu verbinden, um eine integrierte Schaltung vom Typ eines N-Kanal-Ausgangs mit offenem Drain oder eines P-Kanal-Ausgangs mit offenem Drain zu bilden, wobei das Ausgangsverdrahtungsmuster (L1, L2) durch Lithographie gebildet wird, um so lediglich das ausgewählte der Drains zu kontaktieren.

8. Halbleitervorrichtung nach Anspruch 7, ferner mit Elektrodenkontaktfenstern (N3, N4) auf den oberen Abschnitten der Drains (Dp2, Dn2) sowohl des P-Kanal-MIS-Feldeffekttransistors (Tp2) als auch des N-Kanal-MIS-Feldeffekttransistors (Tn2), wobei die Ausgangsverdrahtung (L1) ein Muster hat, das sich auf ein ausgewähltes der Elektrodenkontaktfenster (N3, N4) erstreckt, um so mit dem Drain (Dp2, Dn2) der ausgewählten der N-Kanal- oder P-Kanal-MIS-Feldeffekttransistoren über ein ausgewähltes Elektrodenkontaktfenster verbunden zu werden.

9. Halbleitervorrichtung nach Anspruch 7, ferner mit einem Elektrodenkontaktfenster (N3 oder N4) auf dem oberen Abschnitt des genannten ausgewählten der Drains (Tp2, Tn2) des P-Kanal-MIS-Feldeffekttransistors (Tp2) oder des N-Kanal-MIS-Feldeffekttransistors (Tn2), wobei die Ausgangsverdrahtung ein Muster hat, welches sich auf die oberen Abschnitte der Drains (Dp2 und Dn2) von sowohl dem P-Kanal- als auch dem N-Kanal-MIS-Feldeffekttransistor (Tp2, Tn2) erstreckt, so daß der Ausgangsdraht (L1) über das Elektrodenkontaktfenster (N3 oder N4) lediglich mit dem ausgewählten Drain verbunden wird.

10. Halbleitervorrichtung nach einem der Ansprüche 7, 8 oder 9, bei dem die Drains (Dn2, Dp2) des N-Kanal-MIS-Feldeffekttransistors (Tn2) und des P-Kanal-MIS-Feldeffekttransistors (Tp2) verschiedene Toleranzspannungen haben.

11. Halbleitervorrichtung nach einem der Ansprüche 7, 8, 9 oder 10, bei dem wenigstens eines der Drains (Tn2, Tp2) des N-Kanal-MIS-Feldeffekttransistors (Tn2) und des P-Kanal-MIS-Feldeffekttransistors (Tp2) eine hohe Toleranzspannung im Vergleich zu der Toleranzspannung der Drains der anderen MIS-Feldeffekttransistoren aufweist, die in der Halbleitervorrichtung integriert sind.

## Revendications

1. Procédé de fabrication d'un dispositif semiconducteur par la technique des circuits prédiffusés dans lequel au moins un dispositif semiconducteur est formé incluant un étage de sortie final comprenant un transistor à effet de champ MIS avec une grille, une source et un drain, et dans lequel, lors d'une étape de particularisation, une connexion est effectuée vers l'étage de sortie, caractérisé en ce qu'un transistor MIS à effet de champ à canal P ($T_{p2}$) et un transistor MIS à effet de champ à canal N ($T_{n2}$) sont prévus dans l'étage de sortie final, et en ce que l'étape de particularisation comprend la formation d'une connexion (L, $L_1$) pour relier un seul des deux transistors de sortie à canal P ou à canal N au reste des circuits du dispositif et le drain ($D_{p2}$, $D_{n2}$) de celui choisi du transistor de sortie à canal P ou à canal N simultanément aux bornes de sortie (P), pour former ainsi un circuit intégré du type à sortie à canal P ou à canal N à drain ouvert.

2. Procédé de fabrication d'un dispositif semiconducteur comprenant les étapes suivantes:

former un transistor MIS à effet de champ à canal N ($T_{n2}$) et un transistor MIS à effet de champ à canal P ($T_{p2}$) dans un étage de sortie final d'un dispositif semiconducteur, chacun des transistor à canal N et à canal P comprenant une grille, une source et un drain; et

former une connexion de sortie ($L_1$) connectée à l'un choisi des drains ($D_{n2}$, $D_{p2}$) du transistor MIS à effet de champ à canal N ou à canal P, formant ainsi un circuit intégré du type sortie à drain ouvert à canal N ou du type à sortie à drain ouvert à canal P, et former simultanément une connexion (L) pour connecter celui choisi des transistors MIS à effet de champ à canal N ou MIS à effet de champ à canal P au reste des circuits du dispositif.

3. Procédé selon l'une des revendications 1 ou 2, comprenant en outre l'étape consistant à former des fenêtres de contact d'électrodes sur les parties supérieures des drains du transistor MIS à effet de champ à canal P et du transistor MIS à effet de champ à canal N et dans lequel la formation de la connexion de sortie comprend l'étape consistant à former la connexion de sortie selon une configuration s'étendant seulement vers l'une choisie des fenêtres de contact d'électrodes de sortie que la connexion est seulement reliée à celui choisi des transistors MIS à effet de champ à canal N ou à canal P par l'intermédiaire d'une fenêtre de contact d'électrode choisie.

4. Procédé selon l'une des revendications 1 ou 2, comprenant en outre la formation d'une fenêtre de contact d'électrode sur la partie supérieure du drain de l'un choisi du transistor MIS à effet de champ à canal P ou du transistor MIS à effet de champ à canal N, et dans lequel la formation de la connexion de sortie comprend l'étape consistant à former la connexion de sortie selon une configuration s'étendant sur les parties supérieures des drains du transistor MIS à effet de champ à canal P et du transistor MIS à effet de champ à canal N de sorte que la connexion de sortie est connectée à celui choisi des drains par l'intermédiaire de la fenêtre de contact d'électrode.

5. Procédé selon l'une quelconque des revendications précédentes dans lequel le transistor MIS à effet de champ à canal N et un transistor MIS à effet de champ à canal P sont formés de sortie que leurs drains présentent des tolérances de tension distinctes.

6. Procédé selon l'une quelconque des revendications précédentes dans lequel les drains d'au moins un des transistors MIS à effet de champ à canal N et à canal P sont formés pour présenter une tolérance de tension élevée en comparaison de la tolérance de tension des drains des autres transistors MIS à effet de champ intégrés dans le dispositif semiconducteur.

7. Dispositif semiconducteur comprenant:

un transistor MIS à effet de champ à canal N (Tn2) et un transistor MIS à effet de champ à canal P (Tp2) formés dans un étage de sortie final du dispositif semiconducteur, chacun des transistors à canal N (Tn2) et à canal P (Tp2) comprenant une grille (G), une source (Sp ou Sn) et un drain (Dp2 ou Dn2); et

caractérisé par:

une connexion de sortie comprenant une configuration de plots de sortie (P) et une configuration de connexions de sortie (L1, L2) pour connecter la configuration de plot de sortie (P) et l'un choisi des drains (Dn2, Dp2) du transistor MIS à effet de champ à canal N ou du transistor MIS à effet de champ à canal P (Tn2 ou Tp2) pour former un circuit intégré du type à sortie à drain ouvert à canal N ou du type à sortie à drain ouvert à canal P, la configuration de connexion de sortie (L1, L2) étant formée par photolithogravure de façon à contacter seulement celui choisi des drains.

8. Dispositif semiconducteur selon la revendication 7, comprenant en outre des fenêtres de contact d'électrodes (N3, N4) sur les parties supérieures des drains (Dp2, Dn2) du transistor MIS à effet de champ à canal P (Tp2) et du transistor MIS à effet de champ à canal N (Tn2), la connexion de sortie (L1) ayant une configuration s'étendant sur l'une choisie des fenêtres de contact d'électrodes (N3, N4) de façon à être connectée au drain (Dp2, Dn2) de celui choisi des transistors MIS à effet de champ à canal N ou à canal P par l'intermédiaire d'une fenêtre de contact d'électrode choisie.

9. Dispositif semiconducteur selon le revendication 7, comprenant en outre une fenêtre de contact d'électrode (N3 ou N4) sur la partie supérieure de celui choisi des drains (Dp2, Dn2) du transistor MIS à effet de champ à canal P (Tp2) ou du transistor MIS à effet de champ à canal N (Tn2), la connexion de sortie ayant une configuration qui s'étend sur les parties supérieures des drains (Dp2 et Dn2) des deux transistors MIS à effet de champ à canal P et à canal N (Tp2, Tn2) de sorte que la connexion de sortie (L1) est connectée seulement à celui choisi des drains par l'intermédiaire de la fenêtre de contact d'électrode (N3 ou N4).

10. Dispositif semiconducteur selon l'une quelconque des revendications 7, 8 ou 9, dans lequel les drains (Dn2, Dp2) du transistor MIS à effet de champ à canal N (Tn2) et du transistor MIS à effet de champ à canal P (Tp2) présente des tolérances de tension différentes.

11. Dispositif semiconducteur selon l'une quelconque des revendications 7, 8, 9 ou 10, dans lequel au moins un des drains (Dn2, Dp2) du transistor MIS à effet de champ à canal N (Tn2) et du transistor MIS à effet de champ à canal P (Tp2) présente une tolérance de tension élevée par rapport à la tolérance de tension des drains des autres transistors MIS à effet de champ intégrés dans le dispositif semiconducteur.

*Fig. I A*

*Fig. I B*

*Fig. I C*

Fig. 2A

Fig. 2B

Fig. 2C

## Fig. 3

## Fig. 6

*Fig. 4A*

*Fig. 4B*

*Fig. 4C*

## Fig. 5A

Tp2   GL2   2

Sp   Dp2

Sn   Dn2   1

Tn2   3

## Fig. 5B

Tp2   GL2   2

Sp   N1   Np   Dp2

Sn   N2   Dn2

Tn2   3

## Fig. 5C

L   GL2   VI

Sp   N1   Np   Dp2

P

Lo

Sn   N2   Dn2

L   VI

*Fig. 7A*

*Fig. 7B*

*Fig. 7C*

*Fig. 8A*

*Fig. 8B*

*Fig. 8C*

*Fig. 9A*

*Fig. 9B*

*Fig. 9C*

*Fig. IOA*

*Fig. IOB*

*Fig. IOC*